# EUROPEAN PATENT APPLICATION

(11) **EP 1 156 515 A1**
(43) Date of publication of application: **21.11.2001**
(21) Application number: 00110454.6
(22) Date of filing: 16.05.2000
(51) Int. Cl.: H01L 21/00

(54) **Arrangement for shipping and transporting disc-like objects**

(71) Applicant: Semiconductor 300 GmbH & Co. KG, 01099 Dresden (DE)
(72) Inventor: Peiter, Martin, 01097 Dresden (DE); Lering, Michael, 91088 Bubenreuth (DE)
(74) Representative: Epping, Wilhelm, Dipl.-Ing.

(57) **Abstract**

An arrangement (1) for shipping and transporting objects e.g. substrates, particularly for shipping and transporting disc-like objects such as wafers, flat panels or CD's is described, wherein the arrangement (1) comprises carrier means (2), e.g. a cassette. The carrier means have an inner surface (21) and supports (22) for receiving the objects and being in contact with at least at a part of the edges of the objects. The supports are arranged such that at least two horizontal levels and at least one pitch (P) are formed, wherein each level is defined by at least one support (22) and the levels are essentially parallel to each other. The pitch (P) is present between the upper surface (23) of the supports (22) of one level and the upper surface (23) of the supports (22) of the next level. In order to maximize the number of objects that can be stored within said arrangement (1), the size of pitch (P) is reduced. According to one aspect, the pitch (P) is equal to or less than half of distance (A) or distance (B) and the distance A or B is sufficient for extraction means to have access to an object positioned on the top or the bottom level, respectively. According to another aspect, the pitch (P) is equal to or less than 10mm, preferably 6mm, most preferably 5mm.

## Description

The present invention relates to an arrangement for shipping and transporting objects, particularly for shipping and storing disc-like objects such as wafers, flat panels or CD's.

In the technical field of manufacturing and processing wafers (for example discs on the basis of silicon in the semiconductor industry, flat panels or CDs) it is common and necessary that wafers are frequently moved between different processing stations or sites. Nevertheless, there is a need to store said wafers in such cases that they are not needed for the moment or before they are moved or shipped to the next processing station, respectively. Usually, wafers are stored in currently automated storage arrangements under minienvironment conditions. In the light of the present invention, the term minienvironment defines a localized environment created by an enclosure to isolate a product from contamination and people. The requirement for such a minienvironment is set forth in document "Integrated Minienvironment Design Best Practices", international SEMATECH, Technology Transfer #99033693A-ENG, SEMATECH Technology Transfer, 2706 Montopolis Drive, Austin, TX 78741, USA, http://www.sematech.org for example.

After the last stage of wafer growing production the wafers have to be shipped from the wafer suppliers to their customers (typically Integrated Chip (IC) manufacturers). For this transportation step as well as for the last process in wafer manufacturing, in acceptance and inspection and in transporting the wafers from one storage facility to another inside an IC manufacturing process a specific shipping or transportation arrangement is required.

The arrangements known for this purpose are so called shipping boxes. Front opening Shipping Boxes (FOSB) used to transport and ship 300mm wafers are for example described in the international standard SEMI M31-0699, the content of which is incorporated by means of reference into the description of the present invention. The interior of shipping boxes to which this standard relates, is usually designed in such a way that a non-removable cassette with supports for the wafers as well as wafer capturing mechanisms and end effector exclusion zones are provided.

The common arrangements comprise so called Property Chrystal Packs and so called semistandardized 25 wafer FOSB's. The Chrystal Packs provide supports for up to 13 wafers and the 25 Front Opening Shipping Boxes (FOSB) can receive up to 25 wafers. In both known arrangements the cassette is designed in such a way that the wafers are in a horizontal orientation and that the supports are at least in contact with the edges of the wafers to be stored. The supports are essentially horizontal and aligned in parallel to each other.

The distance from the top of one support to the top of the next support positioned above said first support is usually referred to as the pitch. This pitch is defined in view of the clearance required between the wafers. The clearance is necessary to prevent the wafers from getting into contact with one another and to provide accessibility to the wafers. In the prior art arrangements the pitch is required to be 10mm in order to allow random access with end effectors.

Due to the limitation on the sizing of the pitch, the capacities of the shipping boxes are limited. The maximum number of wafers to be received in such shipping boxes is 13 and 25, respectively. With the increased demand for wafers in particular in the IC industry the number of shipping boxes that are necessary to supply the manufacturer with the required amount of wafers is increasing. As described above the wafers are stored in minienvironments in order to prevent damage or reduction in quality. Also the shipping or transportation has to be performed under specific conditions, in order to avoid shifting of the wafers and contamination by for example dust.

The problem underlying the present invention is therefore to provide for an arrangement for shipping and storing objects, particularly for shipping and storing disc-like objects such as wafers, flat panels or CD's which allows for an larger number of objects to be handled with a minimal constructional effort. In addition, the arrangement should be compatible with facilities already present at the wafer manufacturer and the IC manufacturer.

The inventive concept for solving this problem is to provide for an arrangement that is capable of receiving a larger number of objects compared to the known arrangements, without causing damage to the objects while transport or storage by reducing the pitch between the supports to a minimum.

In particular the problem underlying the present invention is solved by an arrangement according to the independent claim 1 and 3. Further advantages, features, aspects and details of the invention are evident from the dependent claims, the description and the drawings.

According to a first aspect of the present invention an arrangement for shipping and transporting objects, particularly for shipping and transporting disc-like objects such as wafers, flat panels or CD's, is provided, wherein the arrangement comprises carrier means, said carrier means having an inner surface, defining the inner volume of the arrangement for receiving the objects, a front opening and supports receiving the objects and being in contact with at least at a part of the edges of the objects, the supports being arranged such that at least two horizontal levels and at least one pitch (P) as well as distances (A and B) are formed, wherein each level is defined by at least one support and the levels are essentially parallel to each other, the pitch (P) being present between the upper surface of the supports of one level and the upper surface of the supports of the next level, and distance (A) being present between the upper surface of the first level of supports and the bottom portion of the inner surface of the carrier means and distance (B) being present between the upper surface of the last level of supports and the top portion of the inner surface of the carrier means, wherein the pitch (P) is equal to or less than half of distance (A) or distance (B) and the distance A or B is sufficient for extraction means to have access to an object positioned on the top or the bottom level, respectively.

According to a second aspect of the present invention, an arrangement for shipping and transporting objects, particularly for shipping and transporting disc-like objects such as wafers, flat panels or CD's is provided, wherein the arrangement comprises carrier means, said carrier means having an inner surface, defining the inner volume of the arrangement for receiving the objects, a front opening and supports receiving the objects and being in contact with at least at a part of the edges of the objects, the supports being arranged such that at least two horizontal levels and at least one pitch (P) are formed, wherein each level is defined by at least one support and the levels are essentially parallel to each other, the pitch (P) being present between the upper surface of the supports of one level and the upper surface of the supports of the next level, wherein the pitch (P) is equal to or smaller than 10mm, preferably equal to or smaller than 6mm, most preferably equal to or smaller than 5mm.

Even though in some parts of the description reference is made to specific arrangements for the use of wafer shipping and transportation, the invention is not limited to this specific kind of objects, but can be employed for any kind of object which preferably requires a careful handling and specific surrounding conditions such as a minimenvironment. Objects, which are manufactured and handled during wafer growing production are usually named as substrates. The invention will be described with regard to such substrates hereinafter. However, it should be self-evident, that the present invention is not limited to said specific kind of objects.

With the inventive arrangements the drawbacks of the prior art can be overcome. The outer measurements of the arrangements are predetermined by the mechanical interfaces of the prior art facilities to be used with the inventive arrangement. The present invention provides a solution for the above problem while complying with the predetermined outer measurements and thereby avoiding the incurring of additional costs for adapting the inventive arrangement to the prior art interfaces.

The substrates, e.g. wafers stored in the arrangement are spaced from each other with a minimal required clearance in order to avoid contact between the wafers. With this arrangement therefore a larger number of objects, e.g. wafers can be held and transported. On the other hand the distances at the top and at the bottom, respectively, allow access to the substrates via substrate handling means.

According to the first aspect of the present invention, the size of the distances at the top and the bottom are defined by the extraction means to be used. Preferably, the distances are about 10mm.

By decreasing the pitches in the carrier means to the claimed size it has unexpectedly been possible to reduce the facilities necessary for shipping and transporting substrates such as wafers dramatically. With the inventive arrangement the shipping costs for wafers for example were reduced by about 60 to 70 % compared to common 13 wafer shipping boxes with a 10mm pitch and abut 50% compared to common 25 wafer FOSBs.

Hence, the shipping costs for substrates can be drastically reduced by the reduced quantities of carrier means necessary and by a higher package rate per carrier.

In addition the inventive arrangement is advantageous as it can be employed in transportation and shipping processes without necessitating adaptation of facilities the arrangement interacts with. The modularity and interchangeability at mechanical interfaces will be explained by means of an example referring to wafers as objects to be shipped and transported and the mechanical interfaces used in that field. For example for shipping wafers normally FOSBs with a pitch of 10mm are employed. These shipping boxes are loaded and unloaded by automated facilities. In connection with FOSBs for example FOUP (Front Opening Unified Pod) pod openers FIMS (Front Opening Interface Mechanical Standard) can be used. Where the inventive arrangement is employed to provide for example a shipping box holding 50 wafers in a original 25 wafer box, the wafer manufacturer can still employ the same 25 wafer FOUP pod openers (FIMS) for this shipping box.

Advantageously the pitch between the upper surface of one support and the upper surface of a next support is equal to or smaller than 10mm. This sizing is in particular preferred for arrangements to be used for shipping and transporting wafers. The overall height of the carrier means is limited by the further facilities to be used, e.g. a Loadport of a tool according to SEMI standard E 15.1. In conventional shipping boxes (FOSBs) the overall height of the carrier means is for example 206mm for 13 wafer shipping boxes and 326mm for 25 wafer shipping boxes. The distances A and B are at least 12 and 13mm, respectively. Where the known carrier means are replaced by the inventive carrier means, due to the sizing of the pitch, for example conventional 13 wafer shipping boxes can be equipped to hold at least 20 wafers.

Even more advantageously the pitch is equal to or smaller than 6mm, preferably equal to or smaller than 5mm. With this embodiment the number of wafer which can be held in a shipping box can be even increased more. For example a Property Chrystal Pack originally designed to hold 13 wafers, can be supplied with up to 25 wafers if the pitch is 5mm.

In a preferred embodiment of the invention the supports are being formed by projections extending at least from the side portions of the inner surface of the carrier means. This construction of the supports is advantageous as the length of the supports, i.e. their extension towards the center of the carrier means can be adjusted such that on the one hand the substrates are sufficiently supported and on the other hand the overall weight of the carrier means can be kept to a minimum.

Advantageously, at least one support shows a curved recess on its upper surface for receiving at least part of the edges of the substrate. The recesses of all supports in one horizontal level of the carrier means provide together a defined position for the substrate to be received. By this design of the supports, a shifting of the substrates during transport can be avoided to a large extent and the positioning of the substrate, when loading the carrier means, is facilitated.

According to a preferred embodiment a free area is present, which is adjacent to the front opening of the carrier means and extends in the direction towards the center of the carrier means. This area, which with respect to wafers is also referred to as the wafer set-down and extraction volume, is free of supports. By providing such a free area the access to the substrates is not obstructed by the supports. Also a damaging of the supports can be avoided, which might otherwise occur when supports are present in the area adjacent to the front opening of the carrier means.

In one embodiment of the invention the supports next to the free area show a rim extending perpendicular to the support at the edge thereof for preventing the substrate from shifting towards the free space. This rim which is also referred to as a stopper provides additional safety to prevent the substrates from sliding off of the support when the carrier means are tilted. The rim or stopper is preferably of a lower height than the substrate to be held on the support. In a particularly preferred embodiment the rim extends o.7mm or less in a perpendicular direction above the upper surface of the support.

The supports may be integral parts of a U-shaped arch, which is either an integral part of the carrier means or is inserted into horizontal slots in the inner surface of the carrier means. In the first case the adjusting of the supports to provide the required pitches and distances is facilitated, whereas in the latter case the supports of one level can be exchanged easily in case of defects on one support without the necessity of replacing the whole carrier means.

In particular where the substrates, which are to be shipped in or transported with the inventive arrangement, are sensitive to surrounding conditions the inventive arrangement can further comprise a box, hereinafter also referred to as pod for receiving the carrier means, e.g. a cassette. The carrier means according to the invention may be removable or non-removable from the pod. For example wafers are particularly sensitive to any kind of dust, cross-contamination based on outgassing or contamination due to breakage of another wafer. For wafer therefore so called FOSBs may be used with the inventive arrangement.

In a preferred embodiment the pod has a door on the front and the carrier means, e.g. the cassette, are positioned in the pod with the front opening of the carrier means facing the door. Thereby the setting down of the substrates and the extraction of the substrates can take place without the necessity of removing the carrier means, e.g. the cassette from the pod. This way the influences from the surrounding conditions can be kept low also when withdrawing the substrates from the carrier means. The pod may be designed according to SEMI-Standard E47.1, the content of which with respect to the pod is incorporated into the description of the invention by means of reference.

A further aspect of the invention is the use of an arrangement according to the present invention for shipping and storing 300mm wafers. Wafers require a specific treatment also when being shipped or when being transported. For example the wafers must be kept free of dust in order to allow their use in IC manufacturing. Further more wafers are of fairly small thickness and are frequently subject to breakage when not protected sufficiently. Due to these requirements that have to be full filled for transporting and shipping wafers the facilities necessary, such as suction means to prevent dust from entering the pod, are rather complex and expensive. With the use of the inventive arrangement for these purposes the quantity of these facilities can be reduced significantly, whereby the costs are also reduced. In addition the higher packing rate that can be achieved with the use of the inventive arrangement results in a further cost saving.

Preferably the arrangement according to the claims is used in the last process in wafer manufacturing, in acceptance and inspection or in transporting the wafers, e.g. from a Front Opening Shipping Box to a FOUP or open cassette inside an IC manufacturing process. This use of the inventive arrangement is advantageous as, in contrast to carriers, which are to be used in IC manufacturing processes, at that stage of the wafer production or IC manufacturing a random access to the wafers is not necessary. The loading and unloading can rather be performed by extracting the wafers subsequently form the top to the bottom or vice versa.

The invention will now be described in further detail by referring to the figures where embodiments of the inventive arrangements are shown. It should be noted that these embodiments represent non-restrictive examples of the invention and do not restrict the scope of the claims.

The figures show:
Fig. 1: a sectional side view of an embodiment of the inventive arrangement;
Fig. 2: a top view of carrier means;
Fig. 3: a sectional view of a support having a rim and holding an object; and
Fig. 4: a side view of an embodiment of the invention including a box.

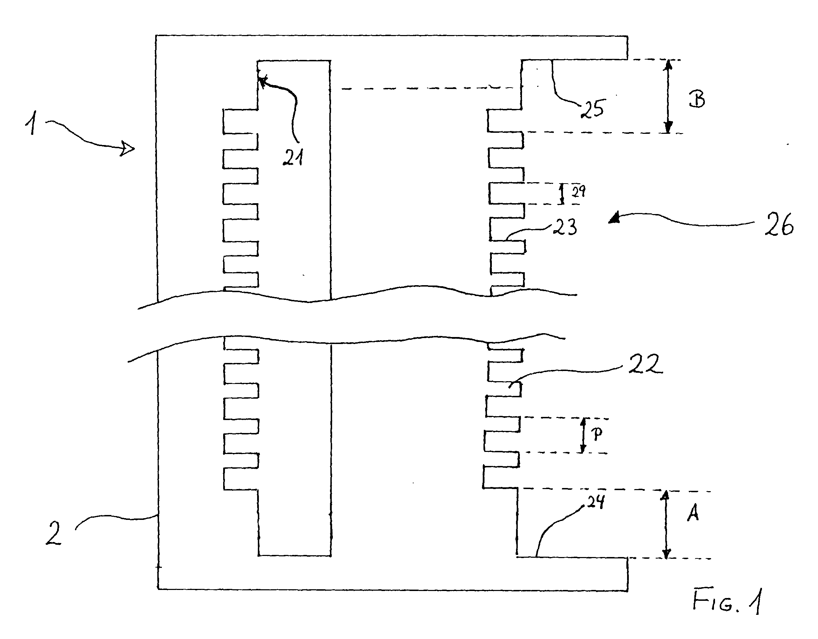

Fig. 1 shows a sectional side view of an arrangement 1 according to the invention. This arrangement 1 can be used to transport or ship for example wafers or CD's.

Fig. 1 illustrates an arrangement only comprising carrier means 2, e.g. a cassette, i.e. without a box or pod surrounding the carrier means 2. Such an arrangement 1 is also referred to as an open carrier or a cassette. On the right hand side of Fig. 1 the front opening 26 of the carrier means 2 is shown. This front opening 26 serves for the set down and extraction of the objects, e.g. substrates. When loading the carrier means 2 the objects are inserted into the volume of the carrier means 2, which is defined by the inner surface 21 thereof. On the sides of the inner surface 21 supports 22 are provided. These supports 22 extend from the sides of the inner surface 21. Each support has an upper surface 23 for receiving the objects, e.g. substrates. The supports 22 are arranged in such a way that the upper surfaces 23 of at least one support 22 forms a horizontal level. The upper surface 23 of the supports 22 of the bottom level are in a distance A from the bottom portion 24 of the inner surface 21 of the carrier means 2. At the top of the carrier means 2 the upper surface 23 of the supports 22 of the top level are in a distance B from the top portion 25 of the inner surface 21 of the carrier means 2.

The various levels formed by the upper surfaces 23 of the supports 22 are arranged in such a way that there is a pitch P between the upper surface 23 of the supports 22 of one level and the upper surface 23 of the supports 22 of the next level above.

According to one aspect of the invention, this pitch P can be equal to or less than half the distance A or B. Either distance A or distance B has to be of sufficient magnitude to allow extraction means to access objects positioned on the top or the bottom level respectively.

In case of an arrangement which is to be used for wafers the magnitude of distances A and B is normally at about 12 and 13mm respectively at the minimum. This distance (A or B) allows sufficient room for automated loading or unloading devices such as robot arms to grip either the top or the bottom wafer positioned in the carrier means 2. Once the first (top or bottom wafer) is removed from the carrier means 2 the subsequent wafer can again be accessed easily.

According to another aspect of the present invention, the pitch P can be reduced or compressed from today = 10mm down to smaller than 10mm, preferably equal or smaller than 6mm, most preferably equal or smaller than 5mm. The invention ist not limited to special pitch sizes. By reduction of the pitch size, the number of objects, e.g. substrates to be stored within said arrangement 1 can be increased.

As can be derived from Fig. 1 the supports 22 forming the various levels for receiving the objects, e.g. substrates extend from the sides of the inner surface 21 of the carrier means 2. These supports 22 can either be produced as an integral part of the carrier means 2 or they can be inserted into the sides of the inner surface 21.

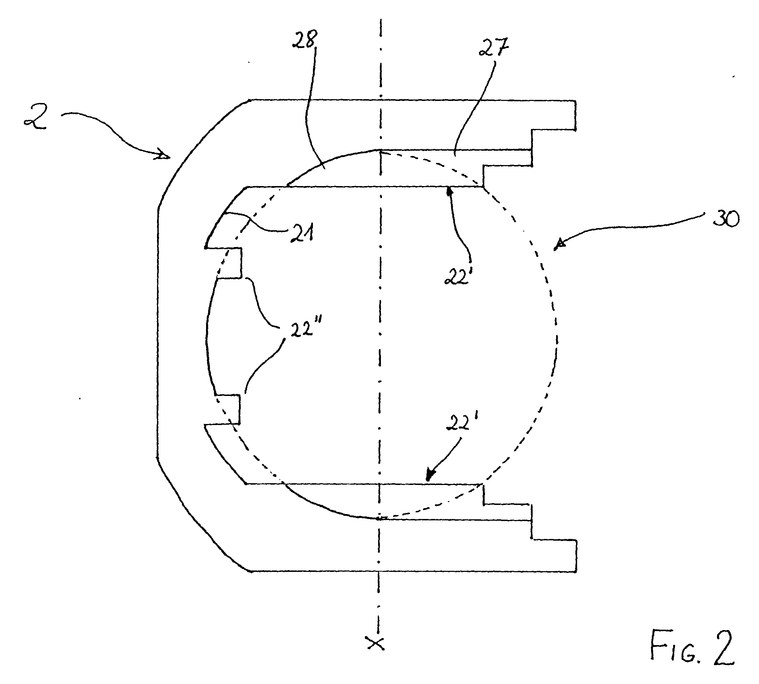

In Fig. 2 a top view of the carrier means 2, e.g cassette 2, according to one embodiment of the invention is shown. For reasons of clarity the top part of the carrier means 2 including the upper portion 25 of the inner surface 21 is not shown.

On the right hand side of Fig. 2 the front opening 26 of the carrier means 2 is shown. The supports 22 are of different shape. In Fig. 2 two supports 22' are shown which are of an elongated shape. These supports 22' are arranged on the sides of the carrier means 2. At the back of the carrier means 2, i.e. at the side opposite to the front opening 26, two smaller supports 22 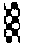 are shown. The supports 22' are straight from the center line X of the of carrier means 2 towards the front opening 26. In the opposite direction the supports 22' have a curved recess 28. By providing the straight portion 27, an easy introduction of the object, e.g. substrate into the carrier means 2 can be ensured. The curved recess 28, on the other hand, prevents the object from shifting and hitting the inner surface 21 of the carrier means 2. At the same time the curved recess 28 facilitates the positioning of the object in the carrier means. Both features can be beneficial to the arrangement of the invention, as the pitch P is minimized and thereby also the clearance 29 is small. It is therefore advantageous if the supports 22 allow for easy positioning in the carrier means 2 and breakage of the objects can be avoided.

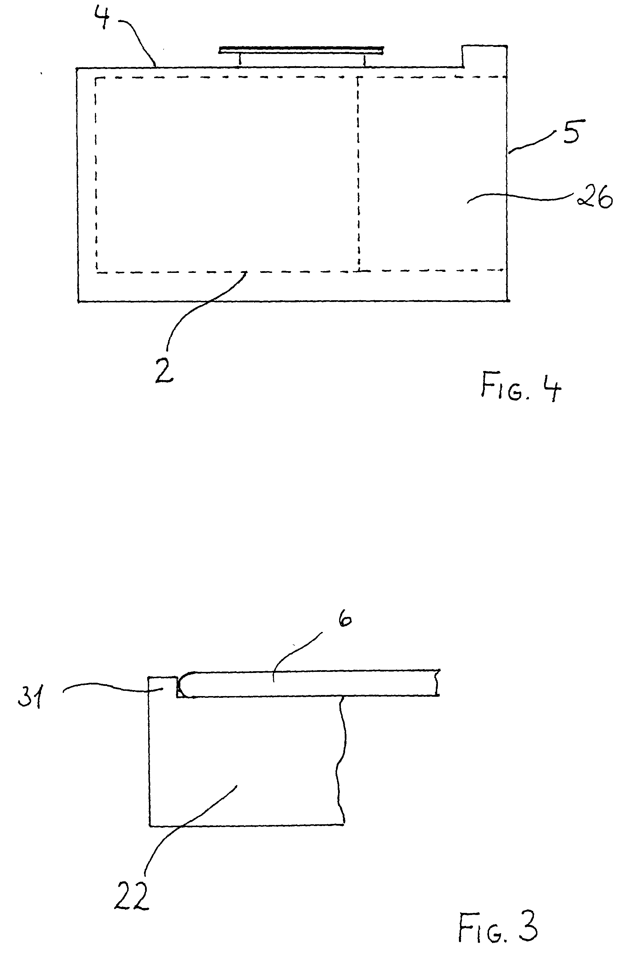

The shape and size of the supports 22 can be adjusted according to the specific needs. It is also within the scope of the invention to provide supports extending from the side of the inner surface 23 to the center of the carrier means 2, if for example the weight of the objects requires additional support. It is, however, important that adjacent to the front opening 26 a free area 30 is provided. This free area 30 allows access to the objects, e.g. substrates. In that free area 30 no supports are provided and hence no obstacles are present. The size of the free area 30 is limited by the requirement of a stable position of the objects, e.g. substrates. In order to increase the stability also rims 31 as shown in Fig. 3 can be provided. These rims 31 are preferably positioned at the edge of the supports 22, which are close to the free area. It is, however, also within the scope of the invention to provide rims 31 by providing the supports 22' of Fig 2 at their straight portion 27 with a curved recess 28 corresponding to the shape of the object, e.g. substrate 6 to be supported. In both cases the rim 31 or curves recess 28 should preferably have a height of less than the height of the object, e.g. substrate in order to facilitate extraction and set down of the objects, e.g. substrates.

Where the arrangement according to the invention is used for objects, e.g. substrates that are sensitive to surrounding conditions, a box (also referred to as pod) may be provided. One embodiment of the arrangement including a pod 4 is shown in Fig 4.

On the right hand side a door 5 is provided to allow access to the objects. Inside of the pod 4 the carrier means 2 are positioned with the front opening 26 facing the door 5.

The arrangement according to the invention can be made of any material appropriate for the specific use. In view of the individual requirements for example metal or plastic can be used. As long as the features of the invention can be realized any manufacturing method for the inventive arrangement can be employed. When the arrangement is made of plastic in particular injection molding may be employed as this method provides the possibility to obtain the arrangement with allowable tolerances. In particular the exact measurement of the pitch is crucial for the manufacturing of the inventive arrangement.

With the sizing of the pitch according to the present invention significant improvements with respect to required quantity of arrangements and packing rate of carrier means can be achieved which result in considerable cost savings.

To summarize the present invention, an arrangement for shipping and transporting objects e.g. substrates, particularly for shipping and transporting disc-like objects such as wafers, flat panels or CD's is described, wherein the arrangement comprises carrier means, e.g. a cassette. The carrier means have an inner surface and supports for receiving the objects and being in contact with at least at a part of the edges of the objects. The supports are arranged such that at least two horizontal levels and at least one pitch (P) are formed, wherein each level is defined by at least one support and the levels are essentially parallel to each other. The pitch (P) is present between the upper surface of the supports of one level and the upper surface of the supports of the next level. In order to maximize the number of objects that can be stored within said arrangement, the size of pitch (P) is reduced. According to one aspect, the pitch (P) is equal to or less than half of distance (A) or distance (B) and the distance A or B is sufficient for extraction means to have access to an object positioned on the top or the bottom level, respectively. According to another aspect, the pitch (P) is equal to or less than 10mm, preferably 6mm, most preferably 5mm.

## Claims

1. Arrangement (1) for shipping and transporting objects, particularly for shipping and transporting disc-like objects such as wafers, flat panels or CD's wherein the arrangement (1) comprises carrier means (2),
- said carrier means (2) having an inner surface (21), defining the inner volume of the arrangement (1) for receiving the objects, a front opening (26) and supports (22) receiving the objects and being in contact with at least at a part of the edges of the objects, the supports being arranged such that
- at least two horizontal levels and at least one pitch (P) as well as distances (A and B) are formed, wherein each level is defined by at least one support (22) and the levels are essentially parallel to each other,
- the pitch (P) being present between the upper surface (23) of the supports (22) of one level and the upper surface (23) of the supports (22) of the next level, and
- distance (A) being present between the upper surface (23) of the first level of supports (22) and the bottom portion (24) of the inner surface (21) of the carrier means (2) and distance (B) being present between the upper surface (23) of the last level of supports (22) and the top portion (25) of the inner surface (21) of the carrier means (2),
wherein the pitch (P) is equal to or less than half of distance (A) or distance (B) and the distance A or B is sufficient for extraction means to have access to an object positioned on the top or the bottom level, respectively.

2. Arrangement according to claim 1,
**characterized in**
**that** the pitch (P) is equal to or smaller than 10mm, preferably equal to or smaller than 6mm, most preferably equal to or smaller than 5mm.

3. Arrangement (1) for shipping and transporting objects, particularly for shipping and transporting disc-like objects such as wafers, flat panels or CD's wherein the arrangement (1) comprises carrier means (2),
- said carrier means (2) having an inner surface (21), defining the inner volume of the arrangement (1) for receiving the objects, a front opening (26) and supports (22) receiving the objects and being in contact with at least at a part of the edges of the objects, the supports being arranged such that
- at least two horizontal levels and at least one pitch (P) are formed, wherein each level is defined by at least one support (22) and the levels are essentially parallel to each other,
- the pitch (P) being present between the upper surface (23) of the supports (22) of one level and the upper surface (23) of the supports (22) of the next level,
wherein the pitch (P) is equal to or smaller than 10mm, preferably equal to or smaller than 6mm, most preferably equal to or smaller than 5mm.

4. Arrangement according to anyone of claims 1 to 3,
**characterized in**
**that** the supports (22) are being formed by projections extending at least from the side portions of the inner surface (21) of the carrier means (2).

5. Arrangement according to anyone of claims 1 to 4,
**characterized in**
**that** the at least one support (22) shows a curved recess (28) on its upper surface (23) for receiving at least part of the edges of the object.

6. Arrangement according to claim anyone of claims 1 to 5,
**characterized in**
**that** a free area (30), adjacent to the front opening (26) of the carrier means (2) and extending in the direction towards the center of the carrier (2) means, is present, which is free of supports (22).

7. Arrangement according to claim 6,
**characterized in**
**that** the supports (22) next to the free area (30) show a rim (31) extending perpendicular to the upper surface (23) of the support (22) for preventing the object from shifting towards the free area (30).

8. Arrangement according to anyone of claims 1 to 7,
**characterized in**
**that** the supports (22) are integral parts of a U-shaped arch.

9. Arrangement according to anyone of claims 1 to 8,
**characterized in**
**that** the arrangement (1) further comprises a box (4) for receiving the carrier means (2).

10. Arrangement according to claim 9,
**characterized in**
**that** the box (4) has a door (5) on the front and the carrier means (2) are positioned in the box (4) with the front opening (26) of the carrier means (2) facing the door (5).

11. Use of an arrangement according to anyone of claims 1 to 10 for shipping and transporting 300mm wafers.

12. Use of an arrangement according to anyone of claims 1 to 10 in the last process in wafer manufacturing, in acceptance and inspection or in transporting the wafers.
